# FASCICULE DE BREVET EUROPEEN

(11) **EP 3 506 336 B1**
(45) Date de publication et mention de la délivrance du brevet: **04.11.2020**
(21) Numéro de dépôt: 18215905.3
(22) Date de dépôt: 26.12.2018
(51) Int. Cl.: H01L 21/311, H01L 29/66

(54) **PROCÉDÉ DE GRAVURE D'UNE COUCHE DIÉLECTRIQUE TRIDIMENSIONNELLE**
ÄTZVERFAHREN EINER DIELEKTRISCHEN 3D-SCHICHT
METHOD FOR ETCHING A THREE-DIMENSIONAL DIELECTRIC LAYER

(30) Priorité: 27.12.2017 FR 1763234
(43) Date de publication de la demande: 03.07.2019
(73) Titulaire: Commissariat à l'Energie Atomique et aux Energies Alternatives, 75015 Paris (FR)
(72) Inventeur: POSSEME, Nicolas, 38360 SASSENAGE (FR); BARNOLA, Sébastien, 38190 VILLARD-BONNOT (FR)
(74) Mandataire: Hautier, Nicolas

(56) Documents cités:
- EP-A1- 2 998 998
- US-A1- 2013 252 430

## Description

### DOMAINE TECHNIQUE DE L'INVENTION

La présente invention concerne en général la gravure de couches sur des structures microélectroniques, notamment tridimensionnelles (3D).

Elle trouve pour application particulièrement avantageuse la réalisation de transistors de type dit FinFET, c'est-à-dire de transistors à effet de champ (FET) dont le canal de conduction comprend une mince lamelle verticale d'un matériau semi-conducteur, qualifiée du terme anglais de « fin ».

### ÉTAT DE LA TECHNIQUE

Dans la course incessante à la réduction des dimensions qui caractérise toute l'industrie de la microélectronique, une difficulté particulière consiste à graver de manière précise une couche située sur certaines ou sur toutes les faces d'une structure 3D sans endommager ou consommer la structure 3D.

Tel est par exemple le cas pour la couche diélectrique destinée à former les espaceurs d'une grille d'un transistor de type FinFET et qui est déposée sur les Fins du transistor comme cela va être expliqué ci-dessous.

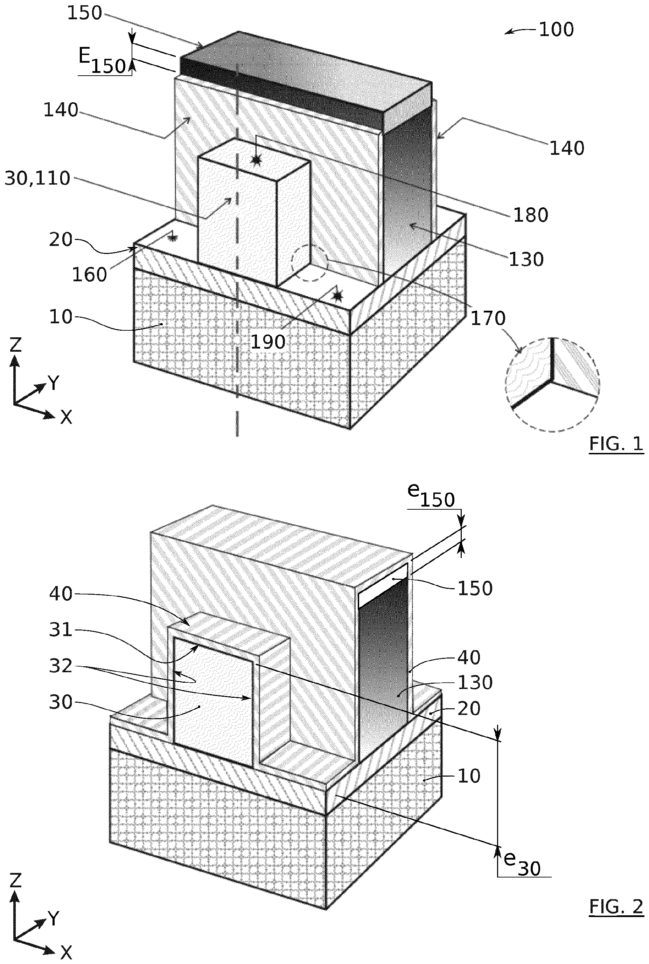

Un transistor 100 de type FinFET est illustré en figure 1. Dans ce dispositif tridimensionnel, le canal 110 de conduction est constitué d'une mince lamelle verticale de matériau semi-conducteur, typiquement du silicium. La lamelle formant le canal 110 est entourée sur trois côtés par la grille 130. La lamelle traverse de part en part la grille 130 et se prolonge pour former de part et d'autre de la grille 130 des nageoires ou «Fin» 30. Ces Fin constituent ainsi des structures tridimensionnelles (3D).

Par rapport aux transistors classiques, ces dispositifs FinFET permettent d'obtenir des transistors ayant de meilleures performances électriques et aussi de réduire les courants de fuite. Le dispositif FinFET ci-dessus pourra être réalisé à partir d'un substrat SOI dont on retrouve la couche de protection enterrée BOX 20 et le substrat 10 de support. On notera aussi la présence d'un masque dur 150 au sommet de la grille 130.

Le dispositif FinFET 100 exige que l'on sache réaliser des espaceurs 140 sur les flancs de la grille 130. Ces espaceurs 140 ont notamment pour fonction de protéger les flancs de la grille 130 lors de phases ultérieures d'implantation.

Pour former ces espaceurs 140, on effectue tout d'abord un dépôt d'une couche uniforme d'un matériau diélectrique sur toutes les surfaces du dispositif 100.

Comme cela est illustré sur la figure 1, on doit pouvoir obtenir par gravure que seuls des espaceurs 140 perpendiculaires au plan du substrat 10 restent en place de part et d'autre de la grille 130. Toutes les autres surfaces, en particulier celles couvrant le Fin 30, qu'elles soient perpendiculaires ou parallèles au plan XY du substrat 10, doivent être gravées complètement. Ceci doit être effectué sans laisser de résidus 160 de couche diélectrique sur la BOX 20 et sans endommager les couches sous-jacente à la couche diélectrique gravée, typiquement sans endommager 180 le sommet 31 des Fin 30 ou sans endommager 190 la face supérieure de la BOX 20. Par ailleurs il est important d'obtenir une gravure parfaitement anisotrope dans les angles 170 sans formation de pieds, ceci afin de conserver des angles bien droits.

Pour répondre à ce besoin, la solution classique consiste à utiliser une gravure plasma pour graver la couche diélectrique. Si la gravure plasma a permis d'accompagner les réductions de taille des motifs jusqu'à présent, sa mise en œuvre pose cependant de plus en plus de problèmes quand la taille diminue, en particulier à partir et au-delà du nœud technologique de 32 nm. Le caractère tridimensionnel (3D) de la structure FinFET fait que les problèmes déjà rencontrés avec une structure plane se posent avec encore plus d'acuité.

En particulier, il est particulièrement complexe de graver entièrement la couche diélectrique 40 sur le sommet 31 et les flancs 32 du Fin 30 sans pour autant endommager le Fin 30 ou laisser des résidus de couche diélectrique 40.

Le document EP 2 998 998 décrit une solution consistant à retirer la couche diélectrique sur les Fin d'un transistor de type FinFET par des implantations selon de directions multiples, ce qui rend le procédé complexe.

Le document US2013/0252430 concerne un procédé visant à réduire l'endommagement des espaceurs de grille de transistors pendant la gravure. Ce document vise à former un espaceur sur les flancs d'une grille mais n'a pas pour objectif de retirer entièrement une couche diélectrique sur les flancs d'une structure. A fortiori, ce document n'aborde pas la problématique liée au retrait d'une couche électrique sur les flancs des Fin tout en conservant cette couche électrique sur les flancs de la grille.

Il existe donc un besoin consistant à proposer une solution pour graver entièrement et avec une grande précision une couche diélectrique située sur des faces d'une structure 3D tout en évitant d'endommager cette structure 3D.

Dans le cadre particulier et non limitatif des transistors de type FinFET, un objectif de la présente invention consiste à proposer une solution pour graver sur les Fins la couche diélectrique destinée à former des espaceurs sur les flancs de la grille, tout en évitant, voire en supprimant, les résidus de couche diélectrique de part et d'autre des Fins ainsi que la consommation de couches sous-jacentes à la couche diélectrique telle que la couche semi conductrice formant le Fin.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, selon un mode de réalisation la présente invention prévoit un procédé de gravure d'une couche diélectrique recouvrant au moins un sommet et un flanc d'une structure de préférence à base d'un matériau semi-conducteur.

Le procédé comprend une pluralité de séquences comprenant chacune au moins les étapes successives suivantes :
- une première gravure de la couche diélectrique, par plasma, en utilisant une chimie comprenant au moins:
   ∘ au moins un premier composé à base de fluor (F) et
   ∘ au moins un deuxième composé pris parmi le Si_{w}Cl_{(2w+2)} et le Si_{w}F_{(2w+2)} w étant un entier non nul,
   ∘ de l'oxygène (O).
   la première gravure étant effectuée de manière à :
   ∘ générer un bombardement ionique dirigé principalement selon une direction parallèle audit flanc,
   ∘ réguler la quantité de l'au moins un premier composé pour consommer tout le composé à base de fluor lors de cette première gravure de manière à interrompre la première gravure avant consommation, selon la direction privilégiée du bombardement, de toute l'épaisseur de la couche diélectrique située sur le flanc et après avoir consommé toute l'épaisseur de la couche diélectrique située sur le sommet,
   ∘ former une première couche de protection par oxydation d'une portion supérieure du sommet de la structure en un matériau semi-conducteur et former une deuxième couche de protection par oxydation d'une portion supérieure de la couche diélectrique située sur le flanc, l'épaisseur e₅₀ₐ de la première couche de protection étant supérieure à l'épaisseur e₆₀ₐ la deuxième couche de protection,
- une deuxième gravure pour retirer entièrement la deuxième couche de protection tout en conservant une portion e_{50b} de l'épaisseur de la première couche de protection.

Avantageusement, la séquence est répétée jusqu'au retrait complet de la couche diélectrique située sur le flanc de la structure.

Ainsi, la présente invention propose une solution efficace pour graver entièrement et avec une grande précision la couche diélectrique sur le sommet et les faces d'une structure 3D tout en évitant d'endommager cette structure 3D.

Typiquement, la gravure est telle que l'on peut contrôler l'arrêt sur la couche de silicium à une échelle atomique.

En effet, la chimie utilisée lors de la première gravure, combinant espèces fluorées et au moins gaz à base de silicium permet de graver efficacement la couche diélectrique, avec une forte sélectivité par rapport au matériau semi-conducteur de la structure 3D. Par ailleurs, cette gravure s'interrompt, lorsque toute l'espèce fluorée est consommée, avant gravure du matériau semi-conducteur de la structure 3D. La présence d'oxygène dans le plasma conduit à la formation d'une couche de protection dont l'épaisseur est plus importante sur le matériau semi-conducteur de la structure 3D que sur la couche diélectrique.

La deuxième gravure permet de retirer la couche de protection sur la couche diélectrique, tout en conservant cette couche de protection sur le matériau semi-conducteur. Lors de la première gravure de la séquence suivante, le matériau semi-conducteur sera donc protégé par le résidu de la première couche de protection ce qui empêchera la gravure de ce dernier, alors que la couche diélectrique ne sera plus protégée par la deuxième couche de protection. La couche diélectrique, mise à nu, se gravera donc aisément.

En répétant cette séquence d'étapes, on grave ainsi rapidement la couche diélectrique tout en consommant extrêmement peu, voire sans consommer le matériau semi-conducteur de la structure 3D.

Lorsque la structure 3D est destinée à former un transistor de type FinFET, la présente invention propose ainsi une solution efficace pour graver la couche diélectrique déposée sur les Fins, tout en évitant, voire en supprimant, les résidus de couche diélectrique en dehors des Fins ainsi que la consommation de couches sous-jacentes à la couche diélectrique telle que la couche semi conductrice formant le Fin.

La solution proposée par la présente invention présente de nombreux avantages.

En particulier, dans le cadre du développement de la présente invention, il s'est avéré que les solutions classiques de gravure des espaceurs en nitrure de silicium (SiN) qui reposent sur l'utilisation de chimie fluorocarbonées (FC) induisent très souvent une consommation (habituellement qualifiée de « recess » en anglais) non souhaitée du silicium formant le Fin du transistor FinFET.

En effet il a été remarqué que la gravure FC de la couche diélectrique induit, en plus d'une consommation de silicium, une modification d'une portion superficielle de la couche de silicium. Cette portion superficielle se transforme en une couche de SixOyFz qui se trouve retirée durant la gravure ou après la gravure durant l'étape de nettoyage humide. Par ailleurs cette portion superficielle modifiée induit des défauts lors de la croissance épitaxiale.

Par ailleurs, pour réduire cette consommation excessive de silicium formant recess, il a été envisagé d'ajuster les conditions d'implantation des ions issus du plasma. Dans un plasma conventionnel, l'énergie minimale des ions est d'environ 20 eV. Avec ce niveau d'énergie en observe des endommagements significatifs de la couche exposée au plasma. Une solution éventuellement envisageable par un homme du métier afin de limiter ces endommagements consisterait à réduire la température Te des électrons, ce qui conduirait à réduire le potentiel du plasma est à réduire par conséquence l'énergie des ions. Une autre solution éventuellement envisageable par un homme du métier consisterait à utiliser un plasma pulsé. Cependant, ces deux solutions ne sont pas satisfaisantes ou ne sont que partiellement satisfaisantes puisque :
- une réduction de la température du plasma conduit à élargir l'angle de distribution des ions, réduisant ainsi le caractère anisotrope de la gravure est dégradant au final le contrôle dimensionnel du profil de la structure 3D,
- l'utilisation d'un plasma pulsé ne permet pas d'éliminer complètement l'endommagement de la couche sous-jacente à la couche diélectrique que l'on souhaite graver.
Ainsi, au mieux, l'homme du métier aurait eu à sa disposition des solutions l'obligeant à effectuer un compromis entre endommagement de la couche sous-jacente et contrôle dimensionnel du profil.

Un autre aspect de la présente invention concerne un procédé de réalisation d'un transistor FinFET surmontant un substrat de support, le transistor FinFET comprenant une grille et au moins un canal traversant la grille et s'étendant depuis un flanc de la grille pour former au moins une structure de préférence faite en un matériau semi-conducteur, ladite structure présentant un sommet et au moins deux flancs.

Le procédé comprend :
- le dépôt, de préférence conforme, d'une couche diélectrique recouvrant la grille et ladite structure,
- la gravure de la couche diélectrique en mettant en oeuvre le procédé selon l'un quelconque des modes de réalisation du procédé de gravure selon l'invention, de manière retirer complètement la couche diélectrique située sur la structure formée par le canal.

De manière facultative, le procédé de réalisation d'un transistor FinFET peut comprendre au moins l'une quelconque des caractéristiques suivantes prises isolément en combinaison :
Selon un exemple de réalisation, le transistor présente un masque dur recouvrant un sommet de la grille, la couche diélectrique étant déposée sur le masque dur, le masque dur présentant une épaisseur e₁₅₀, tel que e₁₅₀ ≥ e₃₀, e₃₀ étant l'épaisseur de ladite structure, et de préférence e₁₅₀ ≥ 1.2 * e₃₀.

Ainsi, lorsque la gravure consomme entièrement la couche diélectrique située sur les flancs de la structure, toute la hauteur des flancs de la grille reste recouverte par la couche diélectrique. Par conséquent, le retrait de la couche diélectrique sur les flancs du Fin n'entraîne pas de retrait de cette couche diélectrique sur les flancs de la grille. Ces derniers restent donc efficacement protégés par les espaceurs.

Selon un exemple de réalisation, les épaisseurs du masque dur et de la structure sont prises selon des directions perpendiculaires (Z) au plan principal (XY) dans lequel s'étend le substrat de support.

Un autre objet de la présente invention concerne un dispositif microélectronique comprenant une pluralité de transistors FinFET selon l'invention. Par dispositif microélectronique, on entend tout type de dispositif réalisé avec des moyens de la microélectronique. Ces dispositifs englobent notamment en plus des dispositifs à Finalité purement électronique, des dispositifs micromécaniques ou électromécaniques (MEMS, NEMS...) ainsi que des dispositifs optiques ou optoélectroniques (MOEMS...).

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 illustre de manière schématique un transistor de type FinFET.
La FIGURE 2 illustre de manière schématique un transistor de type FinFET en cours de réalisation, une couche diélectrique conforme étant déposée sur toutes les surfaces du transistor.
La FIGURE 3 ; composée des FIGURES 3A à 3F illustre de manière schématique des étapes d'un procédé selon un mode de réalisation non limitatif de la présente invention.
La FIGURE 4 est un graphe illustrant la consommation de la couche diélectrique et la consommation de la couche de semi-conducteur en fonction de la présence de SiCl4 dans le plasma.
La FIGURE 5 est un graphe illustrant la consommation de la couche diélectrique en fonction du temps.
La FIGURE 6 illustre l'enchainement des étapes d'un exemple de procédé selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Selon un exemple de réalisation le procédé comprend une étape préalable de dépôt de ladite couche diélectrique sur ladite structure. De préférence, le dépôt de ladite couche diélectrique est un dépôt conforme.

Selon un exemple de réalisation, le procédé comprend une étape préalable de gravure de la couche diélectrique, effectuée avant ladite séquence d'étapes, l'étape préalable de gravure étant interrompue de manière à conserver une portion de la couche diélectrique située sur le sommet de la structure en un matériau semi-conducteur.
Selon un exemple de réalisation, l'étape préalable de gravure de la couche diélectrique est basée sur une chimie fluorocarbonée (par exemple CxFy ou CxHyFz).
Dans la suite de la description, on considère que les chimies fluorocarbonées comprennent notamment les composés fluorocarbonés (CₓF_{z}) et les composés hydrofluorocarbonés (CₓH_{y}F_{z}).

Selon un exemple de réalisation, l'étape préalable de gravure est interrompue en contrôlant le temps de gravure, de manière à ce l'épaisseur e₁₁ gravée de la couche diélectrique lors de cette étape préalable est telle que 0.95 * e₁₀ ≥ e₁₁ ≥ 0.7 * e₁₀, e₁₀ étant l'épaisseur de la couche diélectrique avant gravure par ladite étape préalable. Ainsi, cette étape permet de graver une portion importante de la couche diélectrique. Elle permet d'augmenter la rapidité du procédé.
Selon un exemple de réalisation, e₁₀ ≥ 6 nm et de préférence e₁₀ ≥ 8 nm.
Selon un exemple de réalisation, ladite portion de la couche diélectrique conservée à l'issue de l'étape préalable de gravure présente une épaisseur e₁₂ supérieure ou égale à 2 nm (20⁻⁹ mètres) et de préférence comprise entre 2 et 20 nm.
Cette étape permet ainsi de retirer une partie de l'épaisseur de la couche diélectrique tout en s'assurant que la structure en un matériau semi-conducteur n'est pas gravée ou altérée.

Selon un exemple de réalisation, ledit premier composé à base de fluor (F) de la chimie utilisée pour la première étape de gravure provient, de préférence intégralement, de la chimie utilisée lors de ladite étape préalable de gravure.

Alternativement, une partie au moins et optionnellement tout le premier composé à base de fluor (F) de la chimie utilisée pour la première étape de gravure est fournie durant la première étape de gravure.

Selon un exemple de réalisation, le premier composé à base de fluor (F) provient de la dissociation d'au moins un composé pris parmi les composés fluorocarbonés (par exemple CₓF_{z} ou CₓH_{y}F_{z}).

Selon un exemple de réalisation, la deuxième gravure est une gravure à base d'une chimie fluorée ou fluorocarbonée (par exemple CₓF_{z} ou CₓH_{y}F_{z}).

Selon un exemple de réalisation, la deuxième gravure est contrôlée au temps, de manière à retirer entièrement la deuxième couche de protection et à conserver une partie e_{50b} de l'épaisseur e₅₀ₐ de la première couche de protection.
Ainsi lors d'une gravure ultérieure, le sommet reste protégé par la première couche de protection alors que le flanc est quant à lui non protégé. Ce dernier pourra ainsi être aisément gravé.

Selon un exemple de réalisation, ladite structure est tridimensionnelle (3D).

Selon un exemple de réalisation, la structure en un matériau semi-conducteur est faite en un matériau pris parmi les matériaux suivants: silicium (Si), germanium (Ge), silicium-germanium (SiGe). La structure en un matériau semi-conducteur peut également être faite d'une succession de couches, chaque couche étant par exemple prise parmi les matériaux suivants: silicium (Si), germanium (Ge), silicium-germanium (SiGe). Ainsi pour la réalisation de nanofils on pourra prévoir une succession de couches formée chacune de Si ou de SiGe.

Selon un exemple de réalisation, la structure en un matériau semi-conducteur forme un canal d'un transistor FinFET.

Selon un exemple de réalisation, ledit flanc s'étend selon un plan perpendiculaire (YZ) à un plan principal (XY) selon lequel le substrat de support s'étend. Alternativement, ledit flanc défini une forme courbe qui s'étend perpendiculairement à un plan principal selon lequel le substrat de support s'étend

Selon un exemple de réalisation, ladite structure est formée par au moins un bloc ou une lamelle de matériau semi-conducteur. Alternativement, ladite structure est formée par une couche, éventuellement conforme, présentant une forme tridimensionnelle.

Selon un exemple de réalisation, le sommet s'étend principalement dans un plan parallèle au plan (XY) du substrat de support.

Selon un exemple de réalisation, ladite structure comprend des premières surfaces qui sont perpendiculaires au plan de substrat de support et des deuxièmes surfaces qui sont non perpendiculaires audit plan de substrat de support.

Selon un exemple de réalisation, les flancs de la structure sont perpendiculaires au plan XY dans lequel s'étend principalement le substrat de support. Alternativement, les flancs de la structure sont inclinés par rapport à une direction Z perpendiculaire au plan XY dans lequel s'étend principalement le substrat de support.

Selon un exemple de réalisation, la couche diélectrique est directement au contact de la structure en un matériau semi-conducteur.

Selon un exemple de réalisation, lorsque la couche diélectrique située sur le flanc de la structure est entièrement gravée, on effectue ensuite une étape de retrait de la première couche de protection.

Selon un exemple de réalisation les flancs s'étendent dans des plans perpendiculaires (YZ, ZX) à un plan de base (XY) sur lequel repose la structure, la structure présentant au moins une face, typiquement un sommet, présentant, en projection selon une direction perpendiculaire (Z) au plan de base (XY), une surface non nulle.

Au moins une et de préférence chaque séquence d'étapes comprend, après la première gravure et avant la deuxième gravure une oxydation, dite oxydation principale, conduisant à la formation d'un film d'oxyde sur les surfaces mises à nu.

Selon un exemple, l'oxydation principale est effectuée de sorte à ce que le film d'oxyde présente au moins:
∘ des premières portions formées à la surface de la couche diélectrique recouvrant l'au moins un flanc, les premières portions s'étendant dans un plan perpendiculaire (YZ, ZX) au plan de base (XY),
∘ au moins une deuxième portion formée sur ladite deuxième couche de protection située la couche diélectrique et présentant, en projection selon la direction perpendiculaire (Z) au plan de base (XY), une surface non nulle,
∘ au moins une troisième portion formée sur la première couche de protection et présentant, en projection selon la direction perpendiculaire (Z) au plan de base (XY), une surface non nulle.
La deuxième gravure est effectuée de manière à :
∘ présenter une direction privilégiée (Z) perpendiculaire au plan de base (XY),
∘ retirer entièrement ladite deuxième portion et ladite deuxième couche de protection pour découvrir, selon la direction perpendiculaire (Z) au plan de base (XY), la couche diélectrique située sous la deuxième portion,
∘ être stoppée avant de consommer entièrement lesdites premières portions formées à la surface de la couche diélectrique recouvrant l'au moins un flanc.

Ainsi, le film d'oxyde formé à la surface de la couche diélectrique recouvrant les flancs empêche toute consommation latérale involontaire de cette dernière. La couche diélectrique recouvrant des surfaces perpendiculaires au plan de base XY est donc gravée de manière parfaitement anisotrope, c'est-à-dire uniquement selon la direction privilégiée Z. Le contrôle dimensionnel de l'épaisseur de la couche diélectrique est donc considérablement amélioré.

Lorsque la structure 3D est destinée à former un transistor de type FinFET, la présente invention propose ainsi une solution efficace pour graver la couche diélectrique déposée sur les Fins, tout en évitant, voire en supprimant, les résidus de couche diélectrique en dehors des Fins ainsi que la consommation de couches sous-jacentes à la couche diélectrique telle que la couche semi conductrice formant le Fin.

Par ailleurs, le film d'oxyde formé à la surface de la couche diélectrique permet en outre de préserver le contrôle dimensionnel des espaceurs recouvrant les flancs de la grille.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un film, une couche, « à base » d'un matériau A, un substrat, un film, une couche comprenant ce matériau A uniquement ou ce matériau A et éventuellement d'autres matériaux, par exemple des éléments dopants

Le mot « diélectrique » qualifie un matériau dont la conductivité électrique est suffisamment faible dans l'application donnée pour servir d'isolant.

Le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « nature » d'un matériau, sa composition chimique et/ou sa structure cristalline. Ainsi deux couches peuvent être de même composition chimique mais de nature différente d'un point de vue cristallographique.

Il est précisé que dans le cadre de la présente invention, l'épaisseur d'une couche ou du substrat se mesure selon une direction perpendiculaire à la surface selon laquelle cette couche ou ce substrat présente son extension maximale.

Sauf indication contraire, sur les figures, l'épaisseur est prise selon la verticale, c'est dire selon l'axe Z.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures

Dans le cadre de la présente invention, on désigne par structure en trois dimensions une structure formant une saillie au-dessus d'une couche qui lui est sous-jacente tel un substrat de support ou une structure présentant un profil présentant au moins deux niveaux discrets de hauteurs ou qui présentent un profil analogique avec une variation continue des tangentes de la forme du profil.

Dans le cadre de la présente, un exemple non limitatif mais particulièrement avantageux de structure 3D est une lamelle (également désignée nageoire ou par son vocable anglais Fin) formant l'extension d'un canal de transistor FinFET.

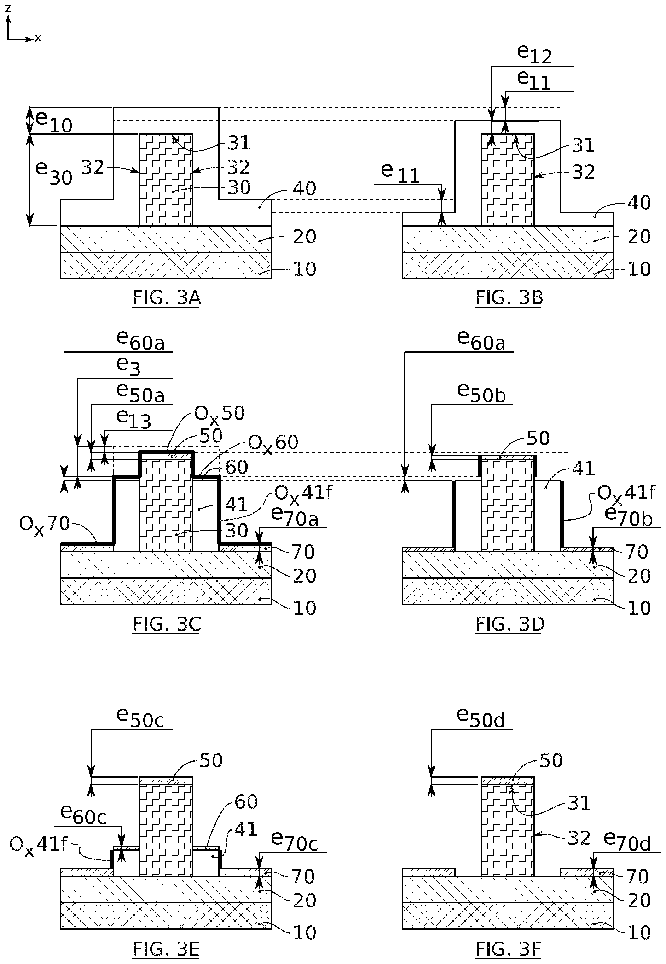

En référence aux figures 2 et 3A à 3F, un exemple non limitatif de l'invention va maintenant être décrit.

Sur ces figures, la couche diélectrique 40 que l'on souhaite graver surmonte une structure tridimensionnelle formée par le Fin 30 d'un transistor FinFET 100. Toutes les caractéristiques, étape et avantages techniques qui vont être décrits par la suite s'appliquent également à des modes de réalisation dans lesquels la couche diélectrique 40 surmonte une structure tridimensionnelle différente d'un Fin d'un transistor FinFET 100. Par exemple ils s'appliquent à des structures formant des nanofils et en particulier des nanofils empilés.

La **figure 2** illustre un transistor FinFET 100 en cours de réalisation. Cette structure comprend un substrat de support 10, surmonté d'une couche isolante 20, typiquement une couche d'oxyde enterré BOX et d'une fine couche semi conductrice. Cet ensemble forme de préférence un substrat élaboré, de préférence de type semi-conducteur sur isolant. Naturellement l'invention s'applique également à un substrat de support ne présentant pas un substrat élaboré de type semi-conducteur sur isolant.

La structure comprend également un empilement de grille 130, qui sera désigné ci-dessous par le terme grille pour des raisons de concision. Cette grille 130 comprend notamment un motif de grille habituellement en silicium dopé ou en métal, une couche métallique et une couche isolante électriquement dite oxyde de grille située entre la couche active et la grille en silicium polycristallin. L'empilement de grille peut également comprendre une couche diélectrique dite « high-k », c'est-à-dire faite d'un matériau à haute permittivité. Lorsqu'elle est présente, cette couche diélectrique est située entre l'oxyde de grille et la grille métallique. Pour des raisons de clarté, sur la figure 2 un seul bloc représente l'ensemble de cet empilement formant la grille 130. Un masque dur 150 surmonte la grille 130. La grille 130 s'étend principalement dans le plan ZX du repère orthogonal XYZ référencé en figure 2.

Un motif traverse la grille 130 de part en part, selon l'axe Y. Ce motif présente généralement une forme de nageoire. Il est désigné Fin 30. Il forme le canal du transistor ainsi que des extensions, situées de part et d'autre de la grille 130, et qui sont destinées à former des zones de source et drain. Ce motif présent un sommet 31 et des flancs 32. Les flancs 32 s'étendent de préférence dans un plan YZ perpendiculaire au plan XY dans lequel s'étend principalement le substrat de support 10. Sur cet exemple, et sans que cela soit limitatif, le sommet 31 s'étend dans un plan parallèle au plan XY. Ainsi, le motif semi-conducteur forme une structure 30 tridimensionnelle. Elle forme une saillie sur la face supérieure de l'empilement de couches comprenant le substrat de support 10 et la couche isolante 20.

Dans cet exemple, la structure 30 est faite en un matériau semi-conducteur, typiquement pris parmi le silicium, le silicium germanium et le germanium. La structure 30 peut également être faite d'un empilement de Si et SiGe, par exemple lorsque la structure 30 forme un nanofil ou une pluralité de nanofils empilés.

La **figure 3A** est une vue en coupe selon un plan parallèle au plan ZX est pris au niveau d'un Fin 30.

La hauteur e30 du Fin 30 est référencée sur cette figure 3A. Par exemple, la hauteur e₃₀ du Fin, mesurée selon la direction Z, est comprise entre quelques nanomètres et quelques dizaines de nanomètres. Préférentiellement, e30 est compris entre 10 et 150 nanomètres et encore plus préférentiellement, e₃₀ est compris entre 20 de 100 nm et encore plus préférentiellement, e₃₀ est compris entre 30 de 50 nm.

Comme illustré en figures 2 et 3A, une couche diélectrique 40 recouvre l'ensemble du transistor en cours de réalisation. De préférence, cette couche diélectrique 40 est une couche conforme.

Dans cet exemple lié aux transistors FinFET, cette couche diélectrique 40 est destinée à former des espaceurs sur les flancs de la grille 130. Cette couche diélectrique 40 est alors formée dans des matériaux présentant une faible constante diélectrique. Cette couche diélectrique 40 peut être poreuse ou non. Elle est par exemple formée dans l'un des matériaux suivants : SiCO, SiC, SiCN, SiOCN ou SiCBN, ou un nitrure de silicium (SixNy, x et y étant des entiers), typiquement du SiN.

Une fois déposée, cette couche diélectrique 40 présente par exemple une épaisseur e₁₀ comprises entre 4 et 50 nanomètres de préférence, entre 4 et 30 nanomètres et de préférence entre 8 et 12 nanomètres. L'épaisseur e₁₀ est mesurée selon la direction Z. Elle est référencée en figure 3A.

À partir de la structure illustrée en figure 3A plusieurs étapes vont être mises en oeuvre dans le but de retirer entièrement la couche diélectrique 40 sur le sommet 31 et sur les flancs 32 du Fin 30 ainsi que de part et d'autre des flancs 32 du Fin 30, ceci, sans laisser de résidus de couche diélectrique et sans endommager les couches sous-jacentes que sont le Fin 30 et la couche isolante 20.

Cette couche diélectrique 40 est par exemple formée par l'une des techniques suivantes: dépôt chimique en phase vapeur assisté par plasma (PECVD, acronyme de plasma enhanced chemical vapor déposition), dépôt chimique en phase vapeur à basse pression (LPCVD, acronyme de low pressure CVD), dépôt par couche atomique assistée par plasma (PEALD, acronyme de plasma enhanced atomic layer déposition).

La **figure 3B** illustre une première étape. Cette étape est optionnelle. Au cours de cette étape, on retire une portion seulement de l'épaisseur de la couche diélectrique sur les zones parallèles au plan XY du substrat 10.

Cette étape de retrait comprend principalement une gravure anisotrope de la couche diélectrique 40. Cette gravure anisotrope permet d'augmenter la rapidité du procédé avant les étapes ultérieures qui vont permettre une gravure très précise. Typiquement, au cours de cette étape préalable de gravure, plus de 70 % et de préférence plus de 80 % et encore plus préférentiellement plus de 90 % de l'épaisseur initiale e₁₀ de la couche diélectrique 40 est gravée. L'épaisseur e₁₁ retirée au cours de cette gravure est de préférence contrôlée au temps.

Typiquement, à l'issue de la gravure, la couche diélectrique 40 présente une épaisseur résiduelle e₁₂ supérieure à 2 nm, de préférence supérieure à 3 nm et de préférence supérieure à 4 nm. Typiquement, l'épaisseur e₁₂ résiduelle est comprise entre 2 et 3 nm. Cette épaisseur e₁₂ résiduelle permet d'éviter que lors de la gravure les couches sous-jacentes à la couche diélectrique 40 soient endommagées.

Cette étape de gravure préalable comprend de préférence une gravure plasma effectuée de manière à ce que la gravure s'opère selon une direction privilégiée parallèle aux flancs de la grille. Ainsi cette gravure est anisotrope. Sur les schémas, la direction privilégiée de gravure anisotrope est parallèle à l'axe Z.

Cette étape de gravure est par exemple effectuée dans un équipement de gravure de type réacteur plasma à couplage inductif (ICP), ou réacteur plasma à couplage capacitif (CCP).

Cette étape de gravure par plasma est basée sur une chimie comprenant un composé à base de fluor (F). De préférence, cette chimie comprend une espèce fluorocarbonée, par exemple pris parmi les espèces suivants CxHyFz ou CxHy, x, y et z étant des entiers. Cette chimie de gravure a pour avantage d'améliorer l'anisotropie de la gravure. Cette anisotropie permet de ne pas graver les surfaces qui sont parallèles à la direction privilégiée d'implantation. Dans le cas d'un transistor FinFET, l'anisotropie de la gravure permet de ne pas graver la couche diélectrique 40 située sur les flancs de la grille 130 et destinée à former les espaces du transistor. Le contrôle dimensionnel de ces espaceurs impactant directement les performances du transistor, il est important de ne pas graver involontairement la couche diélectrique 40 sur les flancs de la grille 130.

De préférence, la chimie fluorocarbonée comprend également au moins une espèce additionnelle de dilution ou de dissociation telle que l'argon (Ar), l'hélium (He), l'azote (N) ou l'oxygène (O).

Le plasma peut être continu ou pulsé.

Les **figures 3C à 3E** illustrent différentes étapes d'une séquence d'étapes qui peut être réitérée jusqu'à obtenir le résultat qui est illustré en figure 3F.

Comme illustré en **figure 3C****,** à l'issue de la gravure préalable, ou après le dépôt de la couche diélectrique 40 (dans le cas où il n'y a pas de gravure préalable), on effectue une première gravure de la couche diélectrique 40.

Cette première gravure est configurée de manière à graver le matériau de la couche diélectrique 40 préférentiellement au matériau de la structure en un matériau semi-conducteur 30. Ainsi, à l'issue de cette première étape de gravure, l'épaisseur e₃ gravée du matériau de la couche diélectrique 40 est supérieure à l'épaisseur e₁₃ gravée du matériau de la couche semi conductrice 30.

Par ailleurs, cette gravure est configurée de manière à:
- s'interrompre avant de consommer toute l'épaisseur e₃₀ de la couche diélectrique 40 située sur le flanc 32 de la structure 30 ;
- former une première couche de protection 50 sur le sommet 31 de la structure 30 en un matériau semi-conducteur et à former une deuxième couche de protection 60 sur une portion supérieure de la couche diélectrique 40 située sur les flancs 32, l'épaisseur e₅₀ₐ de la première couche de protection 50 étant supérieure à l'épaisseur e₆₀ₐ la deuxième couche de protection 60.

Cette première gravure est de préférence une gravure plasma. Cette première gravure de la couche diélectrique 40 utilise une chimie comprenant au moins:
∘ au moins un premier composé à base de fluor (F) et
∘ au moins un deuxième composé pris parmi le Si_{w}Cl_{(2w+2)} et le Si_{w}F_{(2w+2)} w étant un entier non nul,
∘ de l'oxygène (O).
Le premier composé à base de fluor permet une gravure efficace de la couche diélectrique 40 avec une bonne anisotropie.
Le deuxième composé permet d'améliorer la sélectivité de la gravure de la couche diélectrique vis-à-vis des couches sous-jacentes, par exemple faite d'un matériau semi-conducteur ou d'oxyde de silicium (SiO2).
De manière très schématisée en figure 3C, les épaisseurs e₃ et e₁₃ illustrent cette gravure sélective du matériau diélectrique vis-à-vis du matériau semi-conducteur.

La quantité du premier composé à base de fluor est régulée de manière à consommer tous les composés à base de fluor, et donc à interrompre la première gravure avant de consommer toute l'épaisseur (prise selon l'axe Z) de la couche diélectrique 40 qui située sur les flancs 32. Selon un mode de réalisation particulièrement avantageux, le premier composé à base de fluor a été intégralement introduit lors de l'étape préalable de gravure illustrée en figure 3B. Le fluor subsistant à l'issue de cette étape préalable de gravure est utilisé lors de ladite première gravure jusqu'à être entièrement consommé.

Alternativement, une partie ou l'intégralité des composés à base de fluor consommé lors de cette première gravure est introduite dans le réacteur plasma durant cette première gravure.

La présence d'oxygène dans la chimie du plasma permet d'oxyder la surface des couches mises à nu. Tant qu'il y a des composés permettant la gravure des couches, typiquement le composé à base de fluor, la gravure ne permet pas la formation d'une couche d'oxyde. En revanche, une fois que les composés permettant la gravure ont été entièrement consommés, l'oxydation permet la formation d'une couche d'oxyde sur les surfaces mises à nu. Cette oxydation forme des couches de protection référencées :
- 50 sur le sommet 31 de la structure 30. Cette couche de protection 50 est par exemple de type SixOyFz, si la structure 30 est à base de silicium.
- 60 sur les portions supérieures de la couche diélectrique 40 située sur les flancs 32 du Fin 30. Cette couche de protection 60 est par exemple de type SixOyNwFz, si la couche diélectrique 40 est à base de SiN.
- 70 sur la surface de la couche isolante 20. Cette couche de protection 70 est par exemple de type SixOyFz, si la couche isolante 20 est à base de SixOy.

Le matériau semi-conducteur et plus réactif à l'oxygène que le matériau diélectrique. Il s'ensuit que l'épaisseur e₅₀ de la couche de protection 50 formée sur le sommet 31 de la structure 30 est supérieure à l'épaisseur e₆₀ formée sur la portion supérieure de la couche diélectrique 40 située sur les flancs 32 de cette structure 30.

Ainsi, la première couche de protection 50 présente une épaisseur e₅₀ supérieure à celle e₆₀ de la deuxième couche de protection 60. Typiquement, e₅₀ ≥k1. e₆₀, avec k1=1.5 et de préférence k1=2 et de et de préférence k1=3.

De manière avantageuse, la couche de protection 70 formée sur la surface de la couche isolante 20 présente une épaisseur e₇₀ₐ supérieure à celle e₆₀ de la couche de protection 60 située sur la couche diélectrique 40. Typiquement, e₇₀ ≥. k2.e₆₀, avec k2=1.5 et de préférence k2=2 et de et de préférence k2=3.

De préférence, la chimie utilisée pour cette première gravure comprend également des espèces de dilution ou de dissociation telle que l'argon, l'hélium ou l'azote.

Le plasma peut être continu ou pulsé. De manière générale, un plasma pulsé permet de limiter l'endommagement du matériau semi-conducteur de la structure 30.

Par exemple, au cours de cette gravure, on utilise pour le plasma une chimie comprenant :
- du CyHyFz, par exemple du CH3F,
- du SiCl4 dont le débit est compris entre 2 et 15 et de préférence de l'ordre de 5 sccm,
- de l'oxygène,
- éventuellement un gaz de dissociation telle que l'Ar, l'He ou le N2.

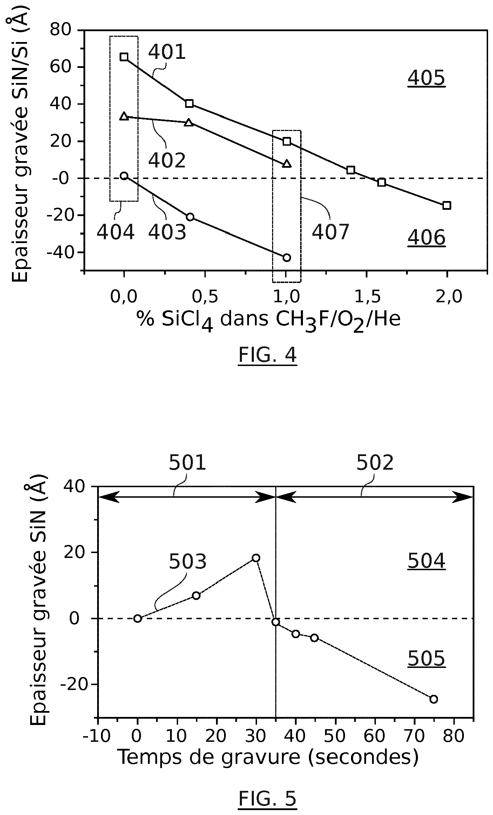

La **figure 4** illustre la consommation de la couche diélectrique 40 et de la structure en un matériau semi-conducteur 30 en fonction de la teneur du plasma en SiCl4. Dans cet exemple, le matériau diélectrique est du SiN et le matériau semi-conducteur de la structure 30 du silicium. Les gaz injectés dans le réacteur plasma, en plus du SiCl4 sont les gaz suivants : CH3F, O2 et He. L'axe des abscisses correspond au pourcentage de SiCl4 injecté dans le réacteur, en termes de débit, par rapport au débit des autres gaz.

La zone 405 correspond un mode de gravure et la zone 406 correspond à un mode de dépôt.

La courbe 401 illustre l'épaisseur gravée du matériau diélectrique. En correspondance avec la figure 3C, il s'agit de l'épaisseur e₃.

La courbe 402 illustre l'épaisseur de silicium consommée par gravure augmentée de l'épaisseur de la couche de protection formée par l'oxyde sur le sommet de la structure en silicium. En correspondance avec la figure 3C, il s'agit de l'épaisseur. Cette épaisseur est par exemple révélée après à bain humide pour enlever la couche de protection.

La courbe 403 illustre l'épaisseur de silicium consommée par gravure. Pour toutes ces courbes, la gravure est de préférence opérée avec un plasma pulsé.

Dans les conditions 404, la chimie du plasma ne contient pas de SiCl4. Il apparaît alors que la consommation de silicium est significative (environ 30 nm), par rapport à la consommation de SiN (environ 65 nm). Par ailleurs, il se forme une épaisseur quasiment nulle de couche de protection en oxyde.

Dans les conditions 407, la chimie du plasma contient 1% SiCl4. Il apparaît alors que la consommation de silicium est très faible (environ 8 Angstrôm soit 0.8 nm), alors que l'on conserve une bonne consommation du SiN (environ 2 nm). Par ailleurs, il se forme une épaisseur importante de couche de protection en oxyde (environ 40 nm).

Les conditions 407 permettent ainsi de graver efficacement le matériau de la couche diélectrique 40, tout en limitant très fortement la consommation de la couche en matériau semi-conducteur 30 et tout en formant une épaisse couche de protection 50. La figure 4 correspond à un temps de procédé donné. Avec un temps plus long, on continuerait à graver le SiN alors que le Si protégé par le dépôt SiOx ne serait pas gravé.

La **figure 5** illustre la consommation de la couche diélectrique 40 au cours du temps de surgravure (Over Etch). Les matériaux ainsi que les chimies utilisées pour établir la courbe de la figure 5 sont identiques à celles utilisées pour établir les courbes de la figure 4.

La période 501 correspond à une période de temps au cours de laquelle le mélange gazeux comprend des espèces fluorocarbonées et plus généralement au moins un composé à base de fluor (F). La période 502 correspond à une période de temps au cours de laquelle le mélange gazeux ne comprend plus de composé à base de fluor (F). La zone 504 correspond un mode de gravure et la zone 505 correspond à un mode de dépôt.

Comme cela apparaît sur cette figure 5, au-delà d'une durée de 30 à 35 secondes, la couche diélectrique 40 n'est plus gravée et la couche de protection 60 en oxyde commence à se déposer sur la couche de nitrure. On peut en déduire que les espèces participant activement à la gravure, telle que le composé à base de fluor (F) ne sont plus présents en quantité suffisante au-delà de cette durée.

Au bout de cette durée, on peut donc interrompre la première gravure dont le résultat est illustré en figure 3C, puis mettre en oeuvre la deuxième gravure dont le résultat est illustré en figure 3D.

L'homme du métier saura élaborer les courbes des figures 4 et 5 pour déterminer des conditions de fonctionnement adaptées aux matériaux et aux épaisseurs de son application. Ainsi, il saura déterminer la teneur en SixCly ou SixFy dans le mélange ainsi que le temps de gravure.

Comme illustré en **figure 3D****,** à l'issue de la première gravure, on effectue une deuxième gravure.

Cette gravure vise à retirer entièrement la deuxième couche de protection 60 située sur la portion supérieure de la couche diélectrique 40 recouvrant les flancs 32 des Fins 30 tout en conservant une portion e_{50b} de la première couche de protection 50 sur le sommet 31 des Fin 30.

Cet objectif est d'autant plus facilement atteint que l'épaisseur e₅₀ de la première couche de protection 50 est plus épaisse que celle e₆₀ de la deuxième couche de protection 60.

Par ailleurs, au cours de cette étape, on conserve également une portion e_{70b} de l'épaisseur de la couche de protection formée au-dessus de la couche isolante 20.

Cette étape est contrôlée au temps.

Cette étape comprend principalement une gravure anisotrope. Typiquement, au cours de l'étape préalable de gravure, une épaisseur d'au moins 1 nm et de préférence d'au moins 1 nm de la couche de protection 50 est consommée.

De préférence, cette épaisseur consommée au cours de cette deuxième gravure est inférieure à 8 nm et de préférence inférieure à 4 nm et de préférence inférieure à 2 nm.

De préférence, cette étape est effectuée de manière à ce que la couche de protection 50 conservée pour protéger le sommet 31 des Fin présente une épaisseur résiduelle e_{50b} telle que e_{50b} ≥ 1 nm et de préférence e_{50b} ≥ 2 nm. Cette épaisseur permet de protéger efficacement les Fin 30.

On notera que, de préférence, la première et/ou la deuxième gravure sont effectuées de sorte à former une couche de passivation sur la partie mise à nu des flancs de la structure 30. Cette couche de passivation typiquement un film d'oxyde permet de protéger efficacement ces flancs contre un bombardement qui ne serait pas parfaitement anisotrope. Ce film d'oxyde peut se former par la simple présence d'oxygène dans la chimie du plasma. Pour des raisons de clarté et puisqu'il est très fin comparativement aux couches d'oxydes 50, 60, ce film d'oxyde n'est pas représenté sur les figures 3c et suivantes.

La deuxième étape de gravure comprend de préférence une gravure plasma effectuée de manière à ce que la gravure s'opère selon une direction privilégiée parallèle aux flancs de la grille. Ainsi cette gravure est anisotrope. Sur les schémas, la direction privilégiée de gravure anisotrope est parallèle à l'axe Z.

Cette étape de gravure est par exemple effectuée dans un équipement de gravure de type réacteur plasma à couplage inductif (ICP), ou réacteur plasma à couplage capacitif (CCP).

Cette étape de gravure par plasma est basée sur une chimie comprenant un composé à base de fluor (F). De préférence, cette chimie comprend une espèce fluorocarbonée, par exemple pris parmi les espèces suivants CxHyFz ou CxHy, x, y et z étant des entiers, tel que le CF4 par exemple ainsi, on pourra utiliser la même chimie que pour l'étape préalable de gravure, de préférence avec une tension de polarisation (habituellement désignée bias) plus faible qu'au cours de la gravure préalable, ceci afin de limiter la consommation des couches sous-jacentes, en particulier de la couche en matériau semi-conducteur.

Il est également possible d'utiliser des chimies à base de SxFy, tel que le SF6. Il faut cependant s'assurer que la gravure avec ce type de chimie ne soit pas trop rapide afin de ne pas endommager la couche de matériau semi-conducteur.

De préférence, la chimie fluorocarbonée comprend également au moins une espèce additionnelle de dilution ou de dissociation telle que l'argon (Ar), l'oxygène (O), l'hélium (He) ou l'azote (N). L'argon peut avoir pour inconvénient de rendre la vitesse de gravure trop élevée. Typiquement, l'épaisseur de la couche de protection que l'on grave au cours de cette deuxième étape de gravure est inférieure à 4 nm et de préférence inférieure à 2 nm. Typiquement, la vitesse de gravure de la couche de protection est de l'ordre de 10 nm/m.

Cette deuxième étape de gravure est interrompue, au temps, après que toute la couche de protection 60 soit consommée et avant que toute la couche de protection 50 soit consommée.

À l'issue de cette deuxième étape de gravure, la séquence d'étapes comprenant la première étape de gravure et la deuxième étape de gravure est réitérée.

Tout au long de chaque séquence, le sommet 31 du Fin 30 reste protégé par la couche de protection 50 formée par oxydation lors de la première étape de gravure de chaque séquence. Il en est de même pour la face supérieure de la couche isolante 20 qui reste protégée par la couche de protection 70. Au cours de chaque première gravure, les portions 41 de couche diélectrique 40 recouvrant les flancs 32 du Fin 30 ont quant à elle été fortement consommées.

La **figure 3E** illustre le résultat de la première étape de gravure d'une séquence additionnelle. On voit sur cette figure 3E que la hauteur e₃₀ du Fin 30 n'a pas été consommée et que le sommet 31 du Fin 30 est toujours recouvert par une couche de protection 50. Les portions 41 de couche diélectrique 40 recouvrant les flancs 32 du Fin 30 ont quant à elles été significativement consommées.

La **figure 3F** illustre le résultat que l'on obtient à l'issue d'une première étape de gravure voire d'une deuxième étape de gravure après avoir réitéré la séquence d'étapes. Comme illustré, les portions 41 de couche diélectrique 40 recouvrant les flancs 32 du Fin 30 sont entièrement consommées. En revanche, la hauteur e₃₀ du Fin 30 n'a pas été consommée ou n'a été que très peu consommée.

Le sommet 31 du Fin 30 ainsi que la face supérieure de la couche isolante 20 sont toujours recouvertes par des couches de protection d'oxyde.

On peut ensuite retirer les couches de protection 50, 70, et éventuellement 60 si elle demeure. Pour cela on pourra par exemple procéder à un retrait par voie humide, par exemple en utilisant un bain HF (acide fluorhydrique). Dans ce cas il est possible que l'on ait une légère consommation de la couche isolante 20 mais les couches de protection à base d'oxyde 50, 60, 70 se graveront plus vite. En effet les couches de protection à base d'oxyde 50, 60, 70 sont peu denses de par leur mode de dépôt. Elles se gravent ainsi beaucoup plus vite qu'une BOX.

Un exemple non limitatif de réalisation va maintenant être décrit.

Le matériau de la couche diélectrique est du nitrure de silicium SiN. Le matériau semi-conducteur de la structure 3D (Fin 30 dans cet exemple) est du silicium (Si).

L'épaisseur initiale e₃₀ du Fin 30 est d'environ 32 et 56 nm. La couche diélectrique 40 présente une épaisseur e₁₀ initiale comprise entre 8 et 12 nanomètres, et d'environ 8 nm dans cet exemple.

La gravure préalable, dont le résultat est illustré en figure 3B peut être opéré en mettant en oeuvre les conditions suivantes :

### I. Gravure préalable:

| | |
|---|---|
| Épaisseur e₁₂ de SiN conservée à l'issue de la gravure: | 2-3 nm |
| Épaisseur e₁₁ de SiN gravée: | 6 nm |
| Chimie : | CHF3: 30 sccm He: 220 sccm |

| Type de plasma | ICP, CCP, pulsé ou continu |
|---|---|
| Puissance de la source : | 300 Watts |
| Tension de polarisation (bias) : | 65 Volts |
| Pression : | 5 milli Torr |
| Température du substrat de support : | 60°C |
| Temps : | 20 secondes |

### II. Séquence d'étapes:

### Première Gravure:

| | |
|---|---|
| | CHF3: 200 sccm |
| | O2: 200 sccm |
| Chimie : | He: 120 sccm |
| | SiCl4: 5 sccm |
| Type de plasma | ICP, CCP |
| Plasma pulsé | 50% à 500Hz |
| Puissance de la source : | 400 Watts |
| Tension de polarisation (bias) : | 250 Volts |
| Pression : | 10 à 100 milli Torr |
| Température du substrat de support : | 60°C entre 20°C et 100°C |

Lors de cette étape, le plasma peut être continu ou pulsé. Un plasma pulsé permet de limiter plus efficacement l'endommagement de la couche de silicium. La fréquence du plasma pulsé est de préférence comprise entre 200 Hz et 5 kHz, de préférence de l'ordre de 500 Hz, avec un taux d'activation de 10% à 90% et typiquement de 50%.

Typiquement, au cours de cette première étape de gravure, on grave une épaisseur e₃ de SiN sur les flancs 32 du Fin 30 d'environ 5 nm. On grave une épaisseur e₁₃ de SiN sur le sommet 31 du Fin 30 d'environ 5 nm.

### Deuxième Gravure:

| | |
|---|---|
| | CF4: 50 sccm |
| Chimie : | O2: 200 sccm |
| Type de plasma | ICP, CCP |
| Plasma, possiblement pulsé | Oui, 50% à 500Hz |
| Puissance de la source : | 1200 Watts |
| Tension de polarisation (bias) : | 50-100V |
| Pression : | 50-100 milli Torr |
| Température du substrat de support : | entre 20°C et 100°C |

Typiquement, au cours de cette première étape de gravure, on grave la couche de protection en oxyde à une vitesse de l'ordre de 10 nm/m.

Typiquement, lors de cette étape, l'épaisseur de couche de protection gravée est inférieure à 2 nm dans cet exemple. Plus généralement, cette épaisseur est inférieure à 4 nm.

Optionnellement, avant gravure de la couche diélectrique 40, c'est-à-dire avant l'étape de gravure préalable si elle est effectuée ou avant la première séquence comprenant les premier et deuxième gravures, on peut effectuer une étape de protection des flancs de la couche diélectrique 40. En effet, au cours des différentes gravures, l'on cherche à graver la couche diélectrique 40 selon une direction Z perpendiculaire au plan XY du substrat 10. Ainsi, il peut être avantageux de limiter la consommation latérale (selon l'axe X) de la couche diélectrique 40. Pour cela, on peut former, de préférence par oxydation, une couche de protection sur la couche diélectrique 40. Cette oxydation est désignée oxydation initiale.

Selon une autre variante, au moins une séquence d'étape et de préférence chaque séquence comprend une étape d'oxydation, désignée oxydation principale. Cette étape est uniquement optionnelle.

La figure 3C illustre également le résultat de cette étape d'oxydation principale. Elle est réalisée, au cours de ladite séquence d'étapes, après la première gravure anisotrope et avant la deuxième gravure anisotrope.

Cette étape forme un film d'oxyde 90 sur toutes les surfaces découvertes.

Ce film d'oxyde 90 se forme notamment sur les surfaces de la couche diélectrique 40,41 qui recouvrent les flancs 32 de la structure 30. Cela permet de protéger la couche diélectrique recouvrant les flancs 32 lors des étapes de gravure anisotrope. En effet, il s'est avéré qu'en dépit de l'anisotrope de ses gravures, une partie de la couche diélectrique 40,41 recouvrant les flancs 32 peut être, involontairement, consommée latéralement (c'est-à-dire selon des directions perpendiculaires à la direction privilégiée Z. La présence de cette couche d'oxyde empêche cette consommation latérale involontaire de la couche diélectrique 40,41.

Cette consommation latérale, même faible, peut présenter des inconvénients majeurs. En effet, dans certaines zones, il est indispensable de parfaitement contrôler l'épaisseur de la couche diélectrique. Tel est par exemple le cas sur les flancs des grilles des transistors. Une consommation, même faible d'une partie de l'épaisseur des espaceurs formés par cette couche diélectrique peut dégrader significativement les performances du transistor.

Ce mode de réalisation permet de contrôler avec encore plus de précisions le dimensionnel de la couche diélectrique destinée à informer les espaceurs. Ce mode de réalisation permet donc d'améliorer encore plus les performances du dispositif microélectronique.

Le résultat de cette étape optionnelle d'oxydation principale est illustré en figures 3C.

Ainsi, comme cela paraît sur cette figure 3C, l'oxydation principale est effectuée de manière à former un film d'oxyde 90, présentant au moins:
∘ des premières portions Ox41f formées à la surface de la couche diélectrique 40, 41 recouvrant l'au moins un flanc 32, les premières portions Ox41f s'étendant dans un plan perpendiculaire YZ, ZX au plan de base XY sur lequel repose la structure 30,
∘ au moins une deuxième portion Ox60 formée sur ladite deuxième couche de protection 60 située la couche diélectrique 40, 41 et présentant, en projection selon la direction perpendiculaire Z au plan de base XY, une surface non nulle,
∘ des troisièmes portions Ox50, Ox70 formées sur les couches de protection 50 et 70 et présentant, en projection selon la direction perpendiculaire Z au plan de base XY, des surfaces non nulles.

La deuxième gravure, dont la figure 3D illustre un exemple de résultat, est effectuée de manière à :
∘ présenter une direction privilégiée Z perpendiculaire au plan de base XY,
∘ retirer entièrement ladite deuxième portion Ox60 et ladite deuxième couche de protection 60 pour découvrir, selon la direction perpendiculaire Z au plan de base XY, la couche diélectrique 40, 41 située sous la deuxième portion Ox60. Ainsi, au cours de la séquence qui suivra, la couche diélectrique 41 pourrait être gravée par la première gravure selon la direction Z.
∘ être stoppée avant de consommer latéralement, c'est-à-dire selon une direction perpendiculaire à la direction Z, la couche diélectrique 40,41 située sur les flancs 32 de la structure 30. De préférence, la deuxième gravure est stoppée avant de graver entièrement lesdites premières portions Ox41f formées à la surface de la couche diélectrique 40, 41 recouvrant l'au moins un flanc 32. De cette manière, on s'assure que la couche diélectrique 40,41 est pas du tout consommée latéralement. Cette gravure est contrôlée au temps.

Ainsi, le film d'oxyde Ox41f formé à la surface de la couche diélectrique 40, 41 recouvrant les flancs empêche toute consommation latérale de cette dernière. La couche diélectrique recouvrant des surfaces perpendiculaires au plan de base XY est donc gravée de manière parfaitement anisotrope, c'est-à-dire uniquement selon la direction privilégiée Z. Le contrôle dimensionnel de l'épaisseur de la couche diélectrique est donc considérablement amélioré.

Lorsque la structure 3D est destinée à former un transistor de type FinFET, la présente invention propose ainsi une solution efficace pour graver la couche diélectrique déposée sur les Fins, tout en évitant, voire en supprimant, les résidus de couche diélectrique en dehors des Fins ainsi que la consommation de couches sous-jacentes à la couche diélectrique telle que la couche semi conductrice formant le Fin.

Par ailleurs, le film d'oxyde formé à la surface de la couche diélectrique permet en outre de préserver le contrôle dimensionnel des espaceurs recouvrant les flancs de la grille.

Ainsi, le procédé selon l'invention prévoit, après chaque étape de première gravure anisotrope, de former un film d'oxyde 90 sur les surfaces mises à nu. Ce film d'oxyde 90 présente une première portion Ox41f sur la surface des portions de la couche diélectrique 40 recouvrant les flancs 32 de la structure 30. Ce film d'oxyde Ox41f s'étend sur toutes les parois perpendiculaires au plan de base XY. Ce film d'oxyde Ox41f protège ainsi ces parois contre toute consommation latérale non souhaitée :
- lors de la deuxième gravure
- puis possiblement, en fonction de l'épaisseur de ce film Ox41f subsistant à l'issue de la deuxième gravure, lors de la première gravure de la séquence suivante qui aura pour objectif de graver la couche diélectrique selon la direction privilégiée Z.

Le procédé selon l'invention permet de protéger ces espaceurs lors de la gravure anisotrope principale qui a pour objectif de consommer la couche diélectrique en dehors des zones d'intérêt.

Typiquement, dans le cas des transistors de type FinFET, et comme cela a été indiqué en introduction, il est nécessaire de retirer la couche diélectrique sur tous les flancs du Fin, tout en conservant la couche diélectrique sur les flancs de la grille.

Le procédé selon l'invention permet de consommer la couche diélectrique de manière parfaitement anisotrope, c'est-à-dire selon la direction privilégiée de gravure. Il est donc possible de retirer toute la hauteur de la couche diélectrique située sur les flancs du Fin, de retirer une hauteur correspondante de couche diélectrique située en regard du masque dur surmontant la grille, sans pour autant graver latéralement la portion de la couche diélectrique située sur les flancs de la grille.

Par ailleurs, à chacune des séquences, la première gravure est stoppée avant de graver la structure en matériau semi-conducteur 30.

Typiquement, si la couche diélectrique 40 est en SiₓN_{y}, alors les premières portions Ox41f du film d'oxyde peuvent être du SiₓO_{y}N_{z}Fₜ x, y, z, t, étant des entiers.

Typiquement, l'épaisseur du film d'oxyde 90 est comprise entre 2 et 4 nanomètres.

Cette étape d'oxydation principale est de préférence effectuée dans un équipement de gravure telle qu'un réacteur de gravure plasma. De préférence le réacteur est un réacteur ICP ou CCP. De préférence, cette étape d'oxydation principale est effectuée dans le même réacteur que les étapes précédentes.

Le plasma permettant l'oxydation est formé à partir d'une chimie à base d'oxygène.

De préférence, la tension de polarisation (habituellement désignée par le vocable anglais bias) est nulle ou très faible afin d'éviter d'endommager le matériau semi-conducteur de la structure 30. De manière plus générale, la tension de polarisation est inférieure à 50 V et de préférence inférieure à 30 V.
La durée de l'oxydation est de préférence comprise entre 5 et 30 secondes et de préférence comprise entre 10 et 20 secondes.

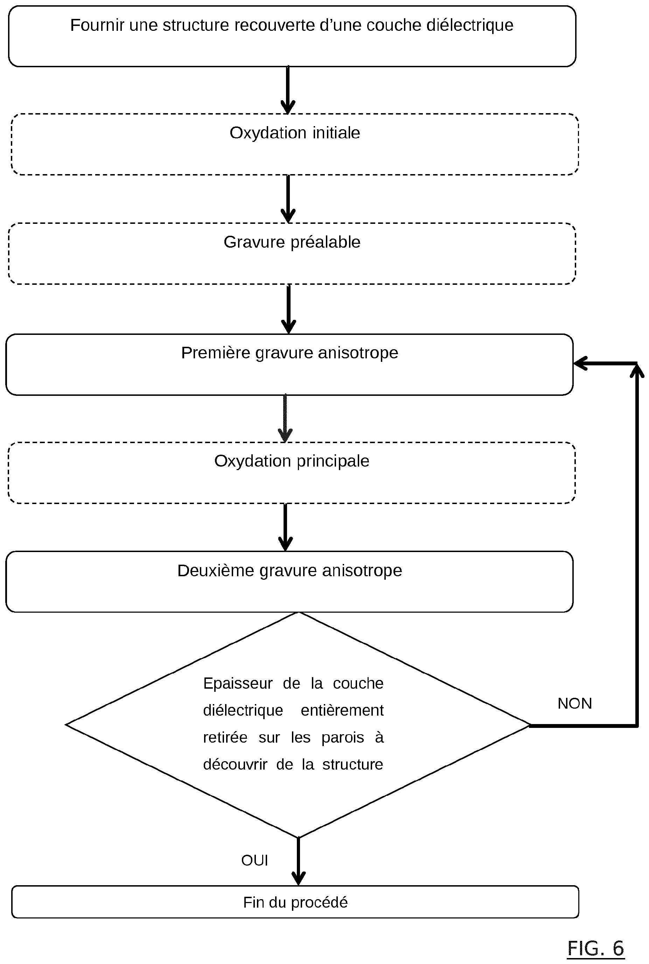

La figure 6 illustre les étapes principales d'un mode de réalisation de la présente invention. Ces étapes sont les suivantes :
- fournir une structure recouverte d'une couche diélectrique,
- oxydation initiale, cette étape étant uniquement optionnelle,
- une ou plusieurs itérations d'une séquence comprenant les étapes suivantes :
   ∘ première gravure anisotrope,
   ∘ oxydation principale, cette étape étant uniquement optionnelle,
   ∘ deuxième gravure anisotrope.
Si toute l'épaisseur, prise selon la direction Z de la couche diélectrique est retirée sur les parois que l'on souhaite entièrement découvrir, alors le procédé est arrêté. Dans le cas contraire, c'est-à-dire s'il subsiste sur des parois que l'on souhaite découvrir une partie de la couche diélectrique, alors on réitère la séquence d'étapes.

Un exemple non limitatif intégrant une étape d'oxydation préalable dans ladite séquence d'étape va maintenant être décrit.

Le matériau de la couche diélectrique est du nitrure de silicium SiN. Le matériau semi-conducteur de la structure 3D (Fin 30 dans cet exemple) est du silicium (Si). On notera que les matériaux suivants pour également convenir à l'exemple mentionné ci-dessous, SiC, SiCN, ou SiCBN.

L'épaisseur initiale e₃₀ de la structure en matériau semi-conducteur, typiquement un Fin d'un transistor FinFET, est d'environ 32 et 56 nm. La couche diélectrique 40 présente une épaisseur e₁₀ initiale comprise entre 8 et 12 nanomètres, et d'environ 8 nm dans cet exemple.

La gravure préalable, dont le résultat est illustré en figure 3B peut être opérée en mettant en oeuvre les conditions suivantes :

### I. Gravure préalable (Figure 3B):

| | |
|---|---|
| Épaisseur de SiN conservée à l'issue de la gravure: | 2-3 nm |
| Épaisseur e₁₁ de SiN gravée: | 6 nm |
| Chimie : | CHF3: 30 sccm |
| | He: 220 sccm |
| Type de plasma | ICP, CCP, pulsé ou continu |
| Puissance de la source : | 300 Watts |
| Tension de polarisation (bias) : | 65 Volts |
| Pression : | 5 milli Torr |
| Température du substrat de support : | 60°C |
| Temps : | 20 secondes |

Les séquences d'étapes dont le résultat est illustré en figure 3D peuvent être opérées en mettant en oeuvre les conditions suivantes :

### II. Séquence d'étapes:

### A. Première Gravure (Figures 3C):

| | |
|---|---|
| | CHF3: 200 sccm ou autre gaz de type |
| | CxHyFz |
| | O2: 200 sccm |
| Chimie : | He: 120 sccm |
| | CH4: 0 à 20 sccm |
| | SiCl4: 5 sccm et plus généralement entre 2 et 15 sccm |
| Type de plasma | ICP, CCP |
| Plasma pulsé | Pulsé entre 10% et 90% ; de préférence 50% |
| | à 200Hz à 5kHz, de préférence 500Hz |
| Puissance de la source : | 400 Watts |
| Tension de polarisation (bias) : | 250 Volts |
| Pression : | 10 à 100 milli Torr, de préférence 90 milli Torr |
| Temps : | Entre 10 et 30s, de préférence 20 secondes |
| Température du substrat de support : | 60°C entre 20°C et 100°C |

Lors de cette étape, le plasma peut être continu ou pulsé. Un plasma pulsé permet de limiter plus efficacement l'endommagement de la couche de silicium. La fréquence du plasma pulsé est de préférence comprise entre 200 Hz et 5 kHz, de préférence de l'ordre de 500 Hz, avec un taux d'activation de 10% à 90% et typiquement de 50%.

Typiquement, au cours de cette première étape de gravure, on grave une épaisseur de SiN sur les flancs 32 du Fin 30 d'environ 5 nm. On grave une épaisseur de SiN sur le sommet 31 du Fin 30 d'environ 5 nm.

### B. Oxydation principale (Figure 3C):

| | |
|---|---|
| Nature de la couche diélectrique 40 | SiN |
| Nature de la structure 30 semiconductrice | Si |
| Épaisseur du film d'oxyde 90 formé par oxydation | 2à 4 nm par exemple |
| Chimie : | O2: 200 sccm |
| Type de plasma | ICP, CCP, pulsé ou continu |
| Puissance de la source : | 1000 Watts |
| Tension de polarisation (bias) : | 0 Volts |
| Pression : | 10 milli Torr |
| Température du substrat de support : | 50°C |
| Temps : | 10 secondes |

Une tension de polarisation nulle permet d'éviter, ou à tout le moins de limiter la consommation de silicium situé sous la couche diélectrique.

### C. Deuxième gravure anisotrope (Figures 3D):

| | |
|---|---|
| | CHF3: 30 sccm |
| Chimie du plasma : | He: 220 sccm |
| Type de plasma | ICP |
| | |
| Puissance de la source : | 300 Watts |
| Tension de polarisation (bias) : | 65 Volts |
| Pression : | 5 milli Torr |
| Température du substrat de support : | 60°C |
| Temps : | 3 secondes |

En alternative, les conditions du tableau suivant peuvent également être appliquées :

| | |
|---|---|
| | CH2F2: 95 sccm |
| | O2: 63 sccm |
| Chimie du plasma : | He: 50 sccm |
| | CH4: 20 sccm |
| Type de plasma | ICP |
| | |
| Puissance de la source : | 400 Watts |
| Tension de polarisation (bias) : | 100 Volts |
| Pression : | 40 milli Torr |
| Température du substrat de support : | 60°C |
| Temps : | 30 secondes |

De préférence, toutes les étapes de ce mode de réalisation sont réalisées dans le même réacteur plasma, ce qui permet de réduire les cycles de fabrication et de réduire le cout de mise en oeuvre du procédé.

Le mode de réalisation qui a été décrit en détail ci-dessus en référence aux figures 3A à 3F et 6, permet de graver rapidement la couche diélectrique selon la direction privilégiée de gravure, tout en contrôlant avec une grande précision encore améliorée le contrôle dimensionnel de la couche diélectrique destinée à former les espaceurs de grille.

Dans le cas de la réalisation d'un transistor FinFET, on souhaite conserver la couche diélectrique 40 sur les flancs de la grille 130 tout en retirant entièrement la couche diélectrique 40 sur les Fins 30. Or, les flancs de la grille 130 et les flancs 32 du Fin 30 sont généralement perpendiculaires au plan principal XY du substrat de support 10 et sont généralement parallèles à la direction principale (Z) d'implantation des ions issus du plasma. Afin d'éviter de consommer la couche diélectrique sur les flancs de la grille 130 lors du retrait de cette même couche sur les flancs des Fins 30, on prévoit que l'épaisseur e₁₅₀ du masque dur 150 surmontant la grille 130 soit supérieure ou égale à l'épaisseur e₃₀ du Fin 30. Ainsi, lorsque la couche diélectrique 40 recouvrant les flancs 32 du Fin 30 sera entièrement consommée, la couche diélectrique 40 aura été consommée sur une partie au moins de l'épaisseur du masque dur mais continuera de recouvrir intégralement les flancs de la grille 130.

Au vu de la description qui précède, il apparaît clairement que la présente invention propose une solution efficace pour graver entièrement et avec une grande précision la couche diélectrique sur le sommet et les faces d'une structure 3D tout en évitant d'endommager cette structure 3D. Typiquement, la gravure de la couche diélectrique se fait avec une précision atomique ou proche de la monocouche gravée.

L'invention n'est pas limitée aux modes de réalisation précédemment décrits et s'étend à tous les modes de réalisation couverts par les revendications.

Par exemple, le procédé peut ne pas comprendre d'étape préalable de gravure. Ainsi, la gravure de la couche diélectrique est uniquement opérée par les séquences comprenant les première et deuxième gravures.

Bien qu'elle trouve pour application particulièrement avantageuse la réalisation des transistors de type FinFET, l'invention s'applique à toutes les gravures d'une couche diélectrique présentant une structure en trois dimensions. Ainsi, elle trouvera pour application la réalisation de nanofils par exemple et en particulier de nanofils empilés.

## Revendications

1. Procédé de gravure d'une couche diélectrique (40) recouvrant au moins un sommet (31) et au moins un flanc (32, 32) d'une structure (30) de préférence à base d'un matériau semi-conducteur,
**caractérisé par le fait qu'**il comprend une pluralité de séquences comprenant chacune au moins les étapes successives suivantes :
- une première gravure de la couche diélectrique (40), par plasma, en utilisant une chimie comprenant au moins:
∘ au moins un premier composé, le premier composé étant à base de fluor (F), et provenant de la dissociation d'au moins un composé pris parmi les composés fluorocarbonés et
∘ au moins un deuxième composé fait d'au moins un gaz à base de silicium et pris parmi le Si_{w}Cl_{(2w+2)} et le Si_{w}F_{(2w+2)} w étant un entier non nul,
∘ de l'oxygène (O).
la première gravure étant effectuée de manière à :
∘ générer un bombardement ionique dirigé principalement selon une direction parallèle audit flanc (32, 32),
∘ réguler la quantité de l'au moins un premier composé pour consommer tout le composé à base de fluor lors de cette première gravure de manière à interrompre la première gravure avant consommation de toute l'épaisseur de la couche diélectrique (40) située sur le flanc (32) et après avoir consommé toute l'épaisseur de la couche diélectrique (40) située sur le sommet (31),
∘ former une première couche de protection (50) par oxydation d'une portion (23) supérieure du sommet (31) de la structure (30) en un matériau semi-conducteur et former une deuxième couche de protection (60) par oxydation d'une portion supérieure de la couche diélectrique (40) située sur le flanc (32), l'épaisseur (e₅₀ₐ) de la première couche de protection (50) étant supérieure à l'épaisseur (e₆₀ₐ) la deuxième couche de protection (60),
- une deuxième gravure pour retirer entièrement la deuxième couche de protection (60) tout en conservant une portion e50b de l'épaisseur de la première couche de protection (50),
la séquence étant réitérée jusqu'au retrait complet de la couche diélectrique (40) située sur le flanc (32) de la structure (30).

2. Procédé selon la revendication précédente comprenant une étape préalable de dépôt de ladite couche diélectrique (40) sur ladite structure (30) et dans lequel ledit dépôt de ladite couche diélectrique (40) est un dépôt conforme.

3. Procédé selon l'une quelconque des revendications précédentes comprenant une étape préalable de gravure de la couche diélectrique (40), effectuée avant ladite séquence d'étapes, l'étape préalable de gravure étant interrompue de manière à conserver une portion de la couche diélectrique (40) située sur le sommet (31) de la structure (30) en un matériau semi-conducteur, de préférence l'étape préalable de gravure de la couche diélectrique (40) étant basée sur une chimie fluorocarbonée.

4. Procédé selon l'une quelconque des deux revendications précédentes dans lequel l'étape préalable de gravure est interrompue en contrôlant le temps de gravure, de manière à ce l'épaisseur e₁₁ gravée de la couche diélectrique (40) lors de cette étape préalable est telle que 0.95 * e₁₀ ≥ e₁₁ ≥ 0.7 * e₁₀, e₁₀ étant l'épaisseur de la couche diélectrique (40) avant gravure par ladite étape préalable.

5. Procédé selon l'une quelconque des deux revendications précédentes dans lequel ladite portion de la couche diélectrique (40) conservée à l'issue de l'étape préalable de gravure présente une épaisseur (e₁₂) supérieure ou égale à 2 nm (20⁻⁹ mètres) et de préférence comprise entre 2 et 20 nm.

6. Procédé selon l'une quelconque des revendications précédentes, dans lequel ledit premier composé à base de fluor (F) de la chimie utilisée pour la première étape de gravure provient, de préférence intégralement, de la chimie utilisée lors de ladite étape préalable de gravure.

7. Procédé selon l'une quelconque des revendications précédentes, dans lequel la deuxième gravure est une gravure à base d'une chimie fluorée ou fluorocarbonée.

8. Procédé selon l'une quelconque des revendications précédentes, dans lequel le deuxième composé est SiCl₄.

9. Procédé selon l'une quelconque des revendications précédentes, dans lequel la deuxième gravure est contrôlée au temps, de manière à retirer entièrement la deuxième couche de protection (60) et à conserver une partie (e_{50b}) de l'épaisseur (e₅₀ₐ) de la première couche de protection (50).

10. Procédé selon l'une quelconque des revendications précédentes, dans lequel la structure (30) en un matériau semi-conducteur forme un canal d'un transistor FinFET.

11. Procédé selon l'une quelconque des revendications précédentes, dans lequel ladite structure (30) est formée par un au moins un bloc ou une lamelle de matériau semi-conducteur ou dans lequel ladite structure (30) est formée par une couche, éventuellement conforme, présentant une forme tridimensionnelle.

12. Procédé de réalisation d'un transistor FinFET (100) surmontant un substrat de support (10), le transistor FinFET (100) comprenant une grille (130) et au moins un canal (110) traversant la grille (130) et s'étendant depuis un flanc de la grille (130) pour former au moins une structure (30) de préférence en un matériau semi-conducteur, ladite structure (30) présentant un sommet (31) et au moins deux flancs (32, 32), le procédé comprenant :
- le dépôt d'une couche diélectrique (40) recouvrant la grille (130) et ladite structure (30),
- la gravure de la couche diélectrique (40) en mettant en œuvre le procédé selon l'une quelconque des revendications précédentes, de manière à retirer complètement la couche diélectrique (40) située sur la structure (30) formée par le canal (110).

13. Procédé selon la revendication précédente dans lequel le transistor (100) présente un masque dur (150) recouvrant un sommet de la grille (130), la couche diélectrique (40) étant déposée sur le masque dur (150), le masque dur (150) présentant une épaisseur e₁₅₀, tel que e₁₅₀ ≥ e3₀, e₃₀ étant l'épaisseur de la structure (30), et de préférence e₁₅₀ ≥ 1.2 * e₃₀.

14. Procédé selon l'une quelconque des revendications précédentes, les flancs (32, 32) s'étendent dans des plans perpendiculaires (YZ, ZX) à un plan de base (XY) sur lequel repose la structure (30), le sommet de la structure (30) présentant, en projection selon une direction perpendiculaire (Z) au plan de base (XY), une surface non nulle, dans lequel au moins une et de préférence chaque séquence d'étapes comprend, après la première gravure et avant la deuxième gravure une oxydation, dite oxydation principale, de manière à former un film d'oxyde (90) sur toutes les surfaces mises à nu.

15. Procédé selon la revendication précédente dans lequel :
l'oxydation principale est effectuée de manière à ce que le film d'oxyde (90) présente au moins:
∘ des premières portions (Ox41f) formées à la surface de la couche diélectrique (40, 41) recouvrant l'au moins un flanc (32, 32), les premières portions (Ox41f) s'étendant dans un plan perpendiculaire (YZ, ZX) au plan de base (XY),
∘ au moins une deuxième portion (Ox60) formée sur ladite deuxième couche de protection (60) située la couche diélectrique (40, 41) et présentant, en projection selon la direction perpendiculaire (Z) au plan de base (XY), une surface non nulle,
et la deuxième gravure étant effectuée de manière à :
∘ présenter une direction privilégiée (Z) perpendiculaire au plan de base (XY),
∘ retirer entièrement ladite deuxième portion (Ox60) et ladite deuxième couche de protection (60) pour découvrir, selon la direction perpendiculaire (Z) au plan de base (XY), la couche diélectrique (40, 41) située sous la deuxième portion (Ox60),
∘ être stoppée avant de consommer entièrement lesdites premières portions (Ox41f) formées à la surface de la couche diélectrique (40, 41) recouvrant l'au moins un flanc (32).

## Patentansprüche

1. Verfahren zum Ätzen einer dielektrischen Schicht (40), die mindestens einen Scheitelpunkt (31) und mindestens eine Flanke (32, 32) einer Struktur (30), vorzugsweise auf Basis eines Halbleitermaterials, bedeckt,
**gekennzeichnet durch** den Umstand, dass es eine Vielzahl von Sequenzen umfasst, die jeweils mindestens die folgenden aufeinanderfolgenden Schritte umfassen
- ein erstes Ätzen der dielektrischen Schicht (40) durch Plasma, unter Verwendung einer Chemie, die mindestens umfasst:
∘ mindestens eine erste Verbindung, wobei die erste Verbindung auf Fluor (F) basiert ist und aus der Dissoziation von mindestens einer aus Fluorkohlenstoffverbindungen gewählten Verbindung stammt und
∘ mindestens eine zweite Verbindung, die aus mindestens einem Gas auf Basis von Silicium besteht und gewählt ist aus Si_{w}Cl_{(2w+2)} und Si_{w}F_{(2w+2)}, wobei w eine ganze, von null verschiedene Zahl ist,
∘ Sauerstoff (O).
wobei das erste Ätzen durchgeführt wird, sodass
∘ ein hauptsächlich entlang einer Richtung parallel zur Flanke (32, 32) gerichteter lonenbeschuss erzeugt wird,
∘ die Menge der mindestens einen ersten Verbindung reguliert wird, um die gesamte Verbindung auf Basis von Fluor während diesem ersten Ätzen zu verbrauchen, sodass das erste Ätzen vor dem Verbrauch der gesamten Dicke der dielektrischen Schicht (40), die sich auf der Flanke (32) befindet, und nachdem die gesamte Dicke der dielektrischen Schicht (40), die sich auf dem Scheitelpunkt (31) befindet, verbraucht ist, unterbrochen wird,
∘ eine erste Schutzschicht (50) durch Oxidation eines oberen Abschnitts (23) des Scheitelpunkts (31) der Struktur (30) aus einem Halbleitermaterial gebildet wird und eine zweite Schutzschicht (60) durch Oxidation eines oberen Abschnitts der dielektrischen Schicht (40), die sich auf der Flanke (32) befindet, gebildet wird, wobei die Dicke (e₅₀ₐ) der ersten Schutzschicht (50) größer ist als die Dicke (e₆₀ₐ) der zweiten Schutzschicht (60),
- ein zweites Ätzen zum vollständigen Entfernen der zweiten Schutzschicht (60) unter Bewahren eines Abschnitts e50b der Dicke der ersten Schutzschicht (50),
wobei die Sequenz bis zur kompletten Beseitigung der dielektrischen Schicht (40), die sich auf der Flanke (32) der Struktur (30) befindet, wiederholt wird.

2. Verfahren nach dem vorstehenden Anspruch, umfassend einen vorhergehenden Schritt des Abscheidens der dielektrischen Schicht (40) auf der Struktur (30) und wobei das Abscheiden der dielektrischen Schicht (40) ein konformes Abscheiden ist.

3. Verfahren nach einem der vorstehenden Ansprüche, umfassend einen vorhergehenden Schritt des Ätzens der dielektrischen Schicht (40), durchgeführt vor der Sequenz von Schritten, wobei der vorhergehende Schritt des Ätzens unterbrochen wird, sodass ein Abschnitt der dielektrischen Schicht (40), die sich auf dem Scheitelpunkt (31) der Struktur (30) aus einem Halbleitermaterial befindet, bewahrt wird, wobei vorzugsweise der vorhergehende Schritt des Ätzens der dielektrischen Schicht (40) auf einer Fluorkohlenstoffchemie basiert.

4. Verfahren nach einem der zwei vorstehenden Ansprüche, wobei der vorhergehende Schritt des Ätzens durch Steuern der Ätzzeit unterbrochen wird, sodass die geätzte Dicke e₁₁ der dielektrischen Schicht (40) bei diesem vorhergehenden Schritt derart ist, dass 0,95 * e₁₀ ≥ e₁₁ ≥ 0,7 * e₁₀, wobei e₁₀ die Dicke der dielektrischen Schicht (40) vor Ätzen durch den vorhergehenden Schritt ist.

5. Verfahren nach einem der zwei vorstehenden Ansprüche, wobei der Abschnitt der am Ende von dem vorhergehenden Schritt des Ätzens bewahrten dielektrischen Schicht (40) eine Dicke (e₁₂) größer als oder gleich 2 nm (20⁻⁹ Meter) und vorzugsweise im Bereich zwischen 2 und 20 nm aufweist.

6. Verfahren nach einem der vorstehenden Ansprüche, wobei die erste Verbindung auf Basis von Fluor (F) der für den ersten Schritt des Ätzens verwendeten Chemie vorzugsweise ausschließlich aus der während des vorhergehenden Schritts des Ätzens verwendeten Chemie stammt.

7. Verfahren nach einem der vorstehenden Ansprüche, wobei das zweite Ätzen ein Ätzen auf Basis einer Fluor- oder Fluorkohlenstoffchemie ist.

8. Verfahren nach einem der vorstehenden Ansprüche, wobei die zweite Verbindung SiCl₄ ist.

9. Verfahren nach einem der vorstehenden Ansprüche, wobei das zweite Ätzen zeitlich gesteuert wird, sodass die zweite Schutzschicht (60) vollständig entfernt wird und ein Teil (e_{50b}) der Dicke (e₅₀ₐ) der ersten Schutzschicht (50) bewahrt wird.

10. Verfahren nach einem der vorstehenden Ansprüche, wobei die Struktur (30) aus einem Halbleitermaterial einen Kanal eines FinFET-Transistors bildet.

11. Verfahren nach einem der vorstehenden Ansprüche, wobei die Struktur (30) durch mindestens einen Block oder eine Lamelle von Halbleitermaterial gebildet wird oder wobei die Struktur (30) durch eine Schicht, gegebenenfalls konform, gebildet wird, die eine dreidimensionale Form aufweist.

12. Verfahren zum Herstellen eines FinFET-Transistors (100), der ein Trägersubstrat (10) überdeckt, wobei der FinFET-Transistor (100) ein Gate (130) und mindestens einen Kanal (110), der das Gate (130) durchquert, umfasst, und sich ab einer Flanke des Gates (130) erstreckt, um mindestens eine Struktur (30), vorzugsweise aus einem Halbleitermaterial, zu bilden, wobei die Struktur (30) einen Scheitelpunkt (31) und mindestens zwei Flanken (32, 32) aufweist, wobei das Verfahren umfasst:
- das Abscheiden einer dielektrischen Schicht (40), die das Gate (130) und die Struktur (30) bedeckt,
- das Ätzen der dielektrischen Schicht (40) durch die Umsetzung des Verfahrens nach einem der vorstehenden Ansprüche, sodass die dielektrische Schicht (40), die sich auf der durch den Kanal (110) gebildeten Struktur (30) befindet, komplett entfernt wird.

13. Verfahren nach dem vorstehenden Anspruch, wobei der Transistor (100) eine Hartmaske (150) aufweist, die einen Scheitelpunkt des Gates (130) bedeckt, wobei die dielektrische Schicht (40) auf der Hartmaske abgeschieden wird, wobei die Hartmaske (150) eine Dicke e₁₅₀ derart aufweist, dass e₁₅₀ ≥ e₃₀, wobei e₃₀ die Dicke der Struktur (30) ist und wobei vorzugsweise e₁₅₀ ≥ 1,2 * e₃₀.

14. Verfahren nach einem der vorstehenden Ansprüche, wobei die Flanken (32, 32) sich in zu einer Basisebene (XY), auf der die Struktur (30) liegt, senkrechten Ebenen (YZ, ZX) erstrecken, wobei der Scheitelpunkt der Struktur (30) als Projektion entlang einer zur Basisebene (XY) senkrechten Richtung (Z) eine von null verschiedene Oberfläche aufweist, wobei mindestens eine und vorzugsweise jede Sequenz von Schritten nach dem ersten Ätzen und vor dem zweiten Ätzen eine Oxidation, die Hauptoxidation, umfasst, sodass ein Oxidfilm (90) auf allen der freigelegten Oberflächen gebildet wird.

15. Verfahren nach dem vorstehenden Anspruch, wobei:
die Hauptoxidation durchgeführt wird, sodass der Oxidfilm (90) mindestens aufweist:
∘ an der Oberfläche der dielektrischen Schicht (40, 41) gebildete erste Abschnitte (Ox41f), die die mindestens eine Flanke (32, 32) bedecken, wobei die ersten Abschnitte (Ox41f) sich in einer zur Basisebene (XY) senkrechten Ebene (YZ, ZX) erstrecken,
∘ mindestens einen auf der zweiten Schutzschicht (60) gebildeten zweiten Abschnitt (Ox60), der die dielektrische Schicht (40, 41) befindet und in Projektion entlang der zur Basisebene (XY) senkrechten Richtung (Z) eine von Null verschiedene Oberfläche aufweisend,
und das zweite Ätzen durchgeführt wird, sodass:
∘ eine privilegierte Richtung (Z) senkrecht zur Basisebene (XY) aufgewiesen wird,
∘ der zweite Abschnitt (Ox6) und die zweite Schutzschicht (60) vollständig entfernt wird, um entlang der zur Basisebene (XY) senkrechten Richtung (Z) die dielektrische Schicht (40, 41), die sich unter dem zweiten Abschnitt (Ox60) befindet, aufzudecken,
∘ vor dem vollständigen Verbrauch der ersten Abschnitte (Ox41f), die an der Oberfläche der dielektrischen Schicht (40, 41) gebildet sind, die die mindestens eine Flanke (32) bedeckt, gestoppt wird.

## Claims

1. A method for etching a dielectric layer (40) covering at least one top (31) and at least one side (32, 32) of a structure (30) preferably based on a semiconductor material,
**characterised by** the fact that it comprises a plurality of sequences each comprising at least the following successive steps:
- a first etching of the dielectric layer (40), by plasma, using a chemistry comprising at least:
∘ at least one first compound, the first compound being based on fluorine (F), and originating from the dissociation of at least one compound taken from fluorocarbon compounds and
∘ at least one second compound made from at least one silicon-based gas and taken from Si_{w}Cl_{(2w+2)} and Si_{w}F_{(2w+2)} w being a non-zero integer,
∘ oxygen (O).
the first etching being carried out so as to:
∘ generate an ion bombardment mainly directed in a direction parallel to said side (32, 32),
∘ regulate the amount of the at least one first compound to consume all the fluorine-based compound during this first etching so as to interrupt the first etching before consuming the entire thickness of the dielectric layer (40) located on the side (32) and after having consumed the entire thickness of the dielectric layer (40) located on the top (31),
∘ form a first protection layer (50) by oxidation of an upper portion (23) of the top (31) of the structure (30) made of a semiconductor material and form a second protection layer (60) by oxidation of an upper portion of the dielectric layer (40) located on the side (32), the thickness (e₅₀ₐ) of the first protection layer (50) being greater than the thickness (e₆₀ₐ) of the second protection layer (60),
- a second etching to completely remove the second protection layer (60) while retaining a portion e_{50b} of the thickness of the first protection layer (50),
the sequence being repeated until completely removing the dielectric layer (40) located on the side (32) of the structure (30).

2. The method according to the preceding claim comprising a preliminary step of depositing said dielectric layer (40) on said structure (30) and wherein said deposition of said dielectric layer (40) is a conformal deposition.

3. The method according to any one of the preceding claims comprising a preliminary step of etching the dielectric layer (40), carried out before said sequence of steps, the preliminary etching step being interrupted so as to keep a portion of the dielectric layer (40) located on the top (31) of the structure (30) made of a semiconductor material, preferably the preliminary step of etching the dielectric layer (40) being based on a fluorocarbon chemistry.

4. The method according to any one of the two preceding claims, wherein the preliminary etching step is interrupted by controlling the etching time, so that the etched thickness e₁₁ of the dielectric layer (40) during this preliminary step is such that 0.95 * e₁₀ ≥ e₁₁ ≥ 0.7 * e₁₀, e₁₀ being the thickness of the dielectric layer (40) before etching by said preliminary step.

5. The method according to any one of the two preceding claims, wherein said portion of the dielectric layer (40) retained at the end of the preliminary etching step has a thickness (e₁₂) greater than or equal to 2 nm (20⁻⁹ metres) and preferably comprised between 2 and 20 nm.

6. The method according to any one of the preceding claims, wherein said first fluorine-based compound (F) of the chemistry used for the first etching step is preferably integrally from the chemistry used in said preliminary etching step.

7. The method according to any one of the preceding claims, wherein the second etching is an etching based on fluorinated or fluorocarbon chemistry.

8. The method according to any one of the preceding claims, wherein the second compound is SiCl₄.

9. The method according to any one of the preceding claims, wherein the second etching is controlled over time, so as to completely remove the second protection layer (60) and to retain a part (e_{50b}) of the thickness (e₅₀ₐ) of the first protection layer (50).

10. The method according to any one of the preceding claims, wherein the structure (30) made of a semiconductor material forms a channel of a FinFET transistor.

11. The method according to any one of the preceding claims, wherein said structure (30) is formed by at least one block or lamella of semiconductor material or wherein said structure (30) is formed by a layer, which is optionally conformal, having a three-dimensional shape.

12. A method for producing a FinFET transistor (100) surmounting a support substrate (10), the FinFET transistor (100) comprising a grid (130) and at least one channel (110) passing through the grid (130) and extending from a side of the grid (130) to form at least one structure (30) preferably made of a semiconductor material, said structure (30) having a top (31) and at least two sides (32, 32), the method comprising:
- the deposition of a dielectric layer (40) covering the grid (130) and said structure (30),
- the etching of the dielectric layer (40) by implementing the method according to any one of the preceding claims, so as to completely remove the dielectric layer (40) located on the structure (30) formed by the channel (110).

13. The method according to the preceding claim wherein the transistor (100) has a hard mask (150) covering a top of the grid (130), the dielectric layer (40) being deposited on the hard mask (150), the hard mask (150) having a thickness e₁₅₀, such that e₁₅₀ ≥ e₃₀, e₃₀ being the thickness of the structure (30), and preferably e₁₅₀ ≥ 1.2 * e₃₀.

14. The method according to any one of the preceding claims, the sides (32, 32) extend in planes (YZ, ZX) perpendicular to a base plane (XY) on which the structure (30) rests, the top of the structure (30) having, in projection in a direction (Z) perpendicular to the base plane (XY), a non-zero surface, wherein at least one and preferably each sequence of steps comprises, after the first etching and before the second etching an oxidation, called main oxidation, so as to form an oxide film (90) over all exposed surfaces.

15. The method according to the preceding claim wherein:
the main oxidation is carried out so that the oxide film (90) has at least:
∘ first portions (Ox41f) formed on the surface of the dielectric layer (40, 41) covering the at least one side (32, 32), the first portions (Ox41f) extending in a plane (YZ, ZX) perpendicular to the base plane (XY),
∘ at least one second portion (Ox60) formed on said second protection layer (60) located on the dielectric layer (40, 41) and having, in projection in the direction (Z) perpendicular to the base plane (XY), a non-zero surface,
and the second etching being carried out so as to:
∘ have a preferred direction (Z) perpendicular to the base plane(XY),
∘ completely remove said second portion (Ox60) and said second protection layer (60) to uncover, in the direction (Z) perpendicular to the base plane (XY), the dielectric layer (40, 41) located under the second portion (Ox60),
∘ be stopped before completely consuming said first portions (Ox41f) formed on the surface of the dielectric layer (40, 41) covering the at least one side (32).
